# EUROPÄISCHE PATENTSCHRIFT

(11) **EP 0 866 976 B1**
(45) Veröffentlichungstag und Bekanntmachung des Hinweises auf die Patenterteilung: **21.03.2001**
(21) Anmeldenummer: 96945888.4
(22) Anmeldetag: 20.11.1996
(51) Int. Cl.: G01R 21/133

(54) **ELEKTRONISCHE MESSEINRICHTUNG**
ELECTRONIC MEASUREMENT DEVICE
DISPOSTIF DE MESURE ELECTRONIQUE

(30) Priorität: 05.12.1995 DE 19545511
(43) Veröffentlichungstag der Anmeldung: 30.09.1998
(73) Patentinhaber: SIEMENS AKTIENGESELLSCHAFT, 80333 München (DE)
(72) Erfinder: WINDSHEIMER, Klaus, D-91174 Spalt (DE); GRIMM, Georg, D-91456 Diespeck (DE)
(86) Internationale Anmeldenummer: DE9602215
(87) Internationale Veröffentlichungsnummer: WO9721106

(56) Entgegenhaltungen:
- EP-A- 0 240 102
- EP-A- 0 408 287
- WO-A-86/03301
- FR-A- 2 357 907
- FR-A- 2 381 317

## Beschreibung

Die Erfindung bezieht sich auf eine elektronische Meßeinrichtung, insbesondere einen Zähler gemäß dem Oberbegriff des Anspruchs 1. Eine derartige Meßeinrichtung ist aus der DE 26 30 959 A1 entsprechend der FR-A-2 357 907 bekannt.

Aus der WO 95/10781 ist eine elektronische Meßeinrichtung bekannt, bei der digitalisierte Meßsignale auf einen Meßfehler überwacht werden. Beim Auftreten eines Meßfehlers wird ein Korrekturimpuls erzeugt, so daß der Meßfehler ausgeglichen ist. Diese Meßeinrichtung findet bevorzugt Verwendung zur Verbrauchsmessung, insbesondere für einen Zähler.

Wird für eine derartige elektronische Meßeinrichtung ein A/D-Wandler verwendet, so wird für diesen in der Regel eine Referenzspannungsquelle benötigt. Dies gilt auch bei Verwendung eines Sigma-Delta-Modulators (ΣΔ-Modulator). An die Referenzspannung werden hohe Anforderungen gestellt, da die Genauigkeit der Meßeinrichtung direkt von der Referenzspannung abhängig ist. Bei einer hohen Meßgenauigkeit ist daher auch eine präzise Referenzspannung erforderlich, deren Erzeugung sehr aufwendig ist, wobei Aussagen über die Betriebssicherheit jedoch nicht unbedingt möglich sind.

Der Erfindung liegt die Aufgabe zugrunde, eine Meßeinrichtung anzugeben, bei der eine hohe Meßgenauigkeit bei gleichzeitiger Kompensation von Meßeinflüssen gegeben ist.

Die Aufgabe wird erfindungsgemäß gelöst mit einer elektronischen Meßeinrichtung gemäß den Merkmalen des Anspruchs 1.

Auf diese Weise ist der gesamte Meßpfad der Signalerfassung auf die Prüfspannung bezogen. Das bedeutet, daß beispielsweise systematische Fehler, insbesondere das Temperaturverhalten des A/D-Wandlers oder ein Einfluß eines vorgeschalteten Multiplexers, erfaßt und kompensiert sind. Somit ist sozusagen eine dynamische Meßfehlerkompensation gegeben.

In einer Ausführungsform der Erfindung dient als neuer Korrekturfaktor ein entsprechend der Differenz korrigierter oder angepaßter erster Korrekturfaktor. Auf diese Weise ist eine einfache dynamische Anpassung des Korrekturfaktors möglich. Gegebenenfalls kann der ursprüngliche Wert zur Sicherheit auch in einem weiteren Speicher hinterlegt bleiben.

In einer alternativen Ausführungsform dient als neuer Korrekturfaktor ein zusätzlicher Korrekturfaktor. Auf diese Weise ist eine Trennung zwischen ursprünglicher Einstellung und dem dynamischen oder aktuellen Faktor möglich. Für die dynamischen Anpassung im Betrieb ist der getrennte Korrekturfaktor zuständig.

Mit Vorteil sind Mittel zur zyklischen Überprüfung der Differenz oder Erzeugung des neuen Korrekturfaktors vorgesehen. Dabei ist eine laufende Kontrolle und Anpassung der Meßgenauigkeit im Hinblick auf eine veränderte Referenzspannung oder sonstiger Meßeinflüsse gegeben. Die Zykluszeiten sind dabei je nach gewünschter Meßgenauigkeit vorgebbar.

Als Meßsignale können Strom- und Spannungssignale dienen wobei die Signalverarbeitungseinrichtung Mittel zur Zählung eines elektrischen Energieverbrauchs umfaßt. Dadurch ist eine bevorzugte Anwendung der Erfindung gegeben. Die Meßeinrichtung dient dann als Zähler.

Mit Vorteil weist der A/D-Wandler einen Sigma-Delta-Modulator (ΣΔ-Modulator) auf. Auf diese Weise ist ein günstiges Zusammenwirken im Hinblick auf eine präzise Meßwertverarbeitung gegeben.

Die Signalverarbeitungseinrichtung erzeugt bevorzugt ein Fehlersignal, wenn die Differenz einen vorgegebenen Grenzwert überschreitet. Dadurch ist eine zusätzliche Fehlerüberwachung gegeben.

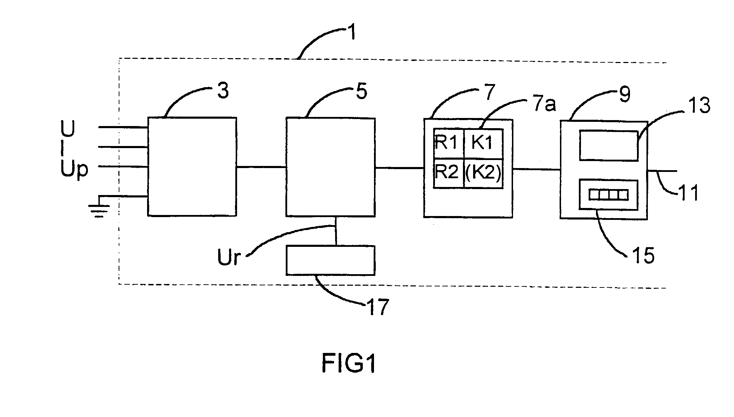

Die Erfindung, weitere Vorteile und Details werden nachfolgend anhand eines Ausführungsbeispiels und der Zeichnung näher erläutert.

Die FIG zeigt eine elektronische Meßeinrichtung 1, die bevorzugt als Zähler für elektrische Energie dient. Prinzipiell ist die Meßeinrichtung auch für andere Anwendungen, z.B. zur Temperaturerfassung und -verarbeitung, einsetzbar, bei denen ein analoges Signal digital verarbeitet werden soll.

Die Meßeinrichtung 1 umfaßt zur Signalerfassung und -verarbeitung eine Reihenschaltung mit einem Multiplexer 3, einem diesen nachgeschalteten A/D-Wandler 5 und einer nachfolgenden digitalen Signalverarbeitungseinrichtung (nachfolgend als Einrichtung 7 bezeichnet). Die Einrichtung 7 weist bevorzugt einen Mikrocomputer und/oder einen digitalen Signalprozessor zur Signalverarbeitung auf. Dadurch erfolgt die gesamte Signalverarbeitung mit Hilfe von Programmen oder Programbausteinen, die gegebenenfalls auch für verschiedene Funktionen doppelt genutzt werden können.
An die Einrichtung 7 schließt sich eine Bedien- und Anzeigeeinrichtung 9 an. Diese weist beispielsweise Anzeigemittel oder ein Display 13, eine Tastatur 15 und/öder eine Schnittstelle 11 auf. Damit ist eine umfassende Datenein- und Ausgabe für Meßeinrichtung 1 gegeben.

Zur Signalerfassung sind der Meßeinrichtung 1 zunächst Meßsignale, insbesondere eine Spannung U und ein Strom I, zugeführt, die über den Multiplexer 3 dem A/D-Wandler 5 zur Digitalisierung zugeführt werden.

Selbstverständlich kann diese Signalerfassung auch mehrkanalig, z.B. zum Erfassen von mehrphasigen Spannungen und Strömen oder zur getrennten Erfassung von Strom und Spannung, aufgebaut sein. In einem solchen Fall wären dann gegebenenfalls mehrere Multiplexer und/oder A/D-Wandler sinngemäß an die Einrichtung 7 angeschlossen.

Der A/D-Wandler 5 benötigt für seine Funktion eine Referenzspannung Ur, die eine Gleichspannung ist. Diese wird dem A/D-Wandler von einer Referenzspannungsquelle 17 zugeführt. Bei Ausbildung der Einrichtung 1 als Baugruppe oder Halblleiterbauteil ist es beispielsweise möglich den Referenzspannungseingang des A/D-Wandlers 5 und den Ausgang der Referenzspannungsquelle 17 getrennt herauszuführen und gegebenenfalls extern durch eine Brücke miteinander zu verbinden. Auf diese Weise sind Kontrolleingriffe möglich, wobei dem A/D-Wandler 5 dann auch eine Spannung einer externen Spannungsquelle zuführbar ist. Bevorzugt ist die Referenzspannungsquelle 17 Bestandteil der Einrichtung 1.

Die Einrichtung 7 weist ein Korrekturglied 7a auf. In einem Speicher des Korrekturgliedes 7a ist ein erster Korrekturfaktor K1 hinterlegt, der einem ersten gespeicherten Referenzwert R1 entspricht. Der Korrekturfaktor K1 kann auch bereits weitere Multiplikatoren oder sonstige Faktoren zur (Rechen-)Vereinfachung beinhalten.

Für die erste Einstellung oder Hinterlegung des Referenzwertes R1, im Sinne einer ersten werkseitigen Einstellung oder Justierung, wird beispielsweise zunächst ein Eingang des Multiplexers 3 auf Masse (Analog Ground; in der FIG als Erdzeichen dargestellt) gelegt und der resultierende digitalisierte Spannungswert zunächst gespeichert. Dieser Wert entspricht der Gleichkomponente der Signalerfassung. Der hierzu verwendete Eingang kann ein spezieller Eingang oder ein für Strom oder'Spannung dienender Eingang sein.

Zusätzlich wird ein hochpräzises Prüfsignal Up (eine als neue Referenz oder neue Basis dienende Prüfspannung) auf einen weiteren Eingang des Multiplexers 3 gegeben. Der resultierende Differenzwert zwischen dem Spannungswert der Gleichkomponente und dem gemessenen Wert des Prüfsignals Up entspricht dem wirklichen Wert des Prüfsignals Up. Dieser Wert wird als erster Referenzwert R1 gespeichert, wodurch sich der resultierende Korrekturfaktor K1 für alle übrigen digitalisierten Meßwerte ergibt.

Während des laufenden Betriebs der Meßeinrichtung 1 wird bevorzugt in zyklischen Abständen ( manuell oder automatisch vorgebbar) ein weiterer Vergleich mit einem Prüfsignal Up durchgeführt. Dies kann vom selben Spannungsgeber oder beispielsweise von einem am Einbauort der Einrichtung 1 installierten Spannungsgeber erzeugt sein. Die Zeitabstände der Zyklen sind je nach Anforderung vorgebbar. Der entsprechende digitalisierte Wert wird als zweiter neuer Referenzwert R2 gespeichert. Hiernach erfolgt ein Vergleich zwischen dem ersten Referenzwert R1 und dem zweiten Referenzwert R2. Liegt eine Differenz vor, so wird ein neuer Korrekturfaktor ermittelt.

Dies kann derart erfolgen, daß beispielsweise der erste Korrekturfaktor K1 neu gebildet oder überschrieben wird, oder daß ein völlig neuer, getrennter Korrekturfaktor K2 in einem weiteren Speicher hinterlegt wird, der dann für den laufenden Betrieb verwendet wird. Auf diese Weise sind Änderungen in der Meßwerterfassungen feststellbar, so daß eine laufende Anpassung und Erhaltung der Meßgenauigkeit erfolgen kann. Bei der ersten Grundeinstellung kann der Korrekturfaktor K2 gleich K1 sein oder einen vorgegebenen Wert, beispielsweise 1, haben.

Sollte die Abweichung zwischen den Werten R1 und R2 einen vorgegebenen Grenzwert überschreiten, so ist es möglich, daß die Einrichtung 7 ein Fehlersignal erzeugt, das dann über die Bedien- und Anzeigeeinrichtung 9 oder über die Schnittstelle 11 an eine übergeordnete Zentrale zur Signalisierung gebracht wird. Das Fehlersignal ist dann ein Zeichen dafür, daß ein erheblicher Meßfehler vorliegt.

Die Meßeinrichtung 1 eignet sich insbesondere für eine Verwendung als Präzisionszähler für Klasse 0,5 oder 0,2. Dabei muß das der Meßeinrichtung 1 zugeführte Prüfsignal Up hochgenau sein und den entsprechenden Anforderungen bezüglich einer Kalibrierung oder Eichung genügen.

Die aufgezeigte Meßeinrichtung hat zum Vorteil, daß die gesamte Signalerfassung oder das Meßsystem auf das externe Prüfsignal, insbesondere dessen Referenzspannung, bezogen ist. Dadurch sind systematische Fehler, wie z.B. der Temperatureinfluß auf den Multiplexer 5 oder auf den Schalterwiderstand bei Verwendung eines Sigma-Delta-Modulators, beseitigt.

Selbstverständlich sind bei Anwendung der Meßeinrichtung als Zähler die einschlägigen Bestimmungen bezüglich Eichung usw. zu berücksichtigen. Eine spezielle Anwendung ist beispielsweise bei einer nicht verrechnungsrelevanten Verbrauchserfassung, z.B. betriebsintern denkbar. Das Prüfsignal Up kann z.B. dauerhaft auf einen Eingang geschaltet sein. Die dazu erforderliche Prüfsignalquelle kann in der Meßeinrichtung 1 eingebaut oder extern angeschlossen sein. Alternativ ist auch ein zweitweiliges oder in vorgebbaren Abständen wiederholtes Anschließen oder Aufschalten möglich.

## Patentansprüche

1. Elektronische Meßeinrichtung (1) mit zumindest einem A/D-Wandler (5), dem Meßsignale(U,I) zugeführt sind und dem eine digitale Signalverarbeitungseinrichtung (7) nachgeschaltet ist,
- wobei die Signalverarbeitungseinrichtung (7) ein Korrekturglied (7a) mit einem ersten gespeicherten Referenzwert (R1) und einem resultierenden ersten Korrekturfaktor (K1) zur Kompensation eines Meßfehlers in der vorgeschalteten Signalerfassung aufweist, und
- wobei dem A/D-Wandler (5) eine Prüfspannung (Up) als Meßsignal zuführbar ist und das Korrekturglied (7a) bei einer Differenz zwischen dem Referenzwert (R1) und dem Wert (R2) der Prüfspannung einen neuen Korrekturfaktor (K1,K2) erzeugt,
**dadurch gekennzeichnet,** daß der neue Korrekturfaktor der entsprechend der Differenz korrigierte erste Korrekturfaktor (K1) oder ein zusätzlicher Korrekturfaktor (K2) ist, und daß der A/D-Wandler an eine Referenzspannungsquelle (17) zum Betrieb angeschlossen ist.

2. Elektronische Meßeinrichtung nach Anspruch 1 mit Mitteln zur zyklischen Überprüfung der Differenz.

3. Elektronische Meßeinrichtung nach einem der Ansprüche 1 oder 2, wobei dem A/D-Wandler (5) als Meßsignale Strom- und Spannungssignale (U,I)) zugeführt sind und die Signalverarbeitungseinrichtung (7) Mittel zur Zählung eines elektrischen Energieverbrauchs umfaßt.

4. Elektronische Meßeinrichtung nach einem der Ansprüche 1 bis 3, wobei der A/D-Wandler (5) einen Sigma-Delta-Modulator umfaßt.

5. Elektronische Meßeinrichtung nach einem der Ansprüche 1 bis 4, wobei die Signalverarbeitungseinrichtung (7) ein Fehlersignal aufweist, wenn die Differenz einen vorgegebenen Grenzwert überschreitet.

## Claims

1. Electronic measuring device (1) having at least one A/D converter (5), to which A/D converter measurement signals (U, I) are supplied and downstream of which a digital signal processing device (7) is connected,
- wherein the signal processing device (7) has a correction element (7a) with a first stored reference value (R1) and a resulting first correction factor (K1) for compensation of a measurement error in the upstream signal detection, and
- wherein a test voltage (Up) can be supplied to the A/D converter (5) as a measurement signal and the correction element (7a) generates a new correction factor (K1, K2) in the case of a difference between the reference value (R1) and the value (R2) of the test voltage,
characterised in that the new correction factor is the first correction factor (K1) corrected in accordance with the difference or an additional correction factor (K2), and in that the A/D converter is connected to a reference-voltage source (17) for operation.

2. Electronic measuring device according to claim 1 having means for cyclically checking the difference.

3. Electronic measuring device according to one of claims 1 or 2, wherein current signals and voltage signals (U, I) are supplied to the A/D converter (5) as measurement signals, and the signal processing device (7) comprises means for metering an electrical power consumption.

4. Electronic measuring device according to one of claims 1 to 3, wherein the A/D converter (5) comprises a sigma-delta modulator.

5. Electronic measuring device according to one of claims 1 to 4, wherein the signal processing device (7) has an error signal if the difference exceeds a predetermined limit value.

## Revendications

1. Dispositif (1) électronique de mesure comprenant au moins un convertisseur (5) analogique/numérique auquel sont envoyés des signaux (U, I) de mesure et en aval duquel est monté un dispositif (7) numérique de traitement du signal,
- le dispositif (7) de traitement du signal comporte un organe (7a) de correction ayant une première valeur (R1) de référence mémorisée et un premier facteur (K1) de correction qui en résulte en vue de la compensation d'une erreur de mesure dans la détection du signal en amont, et
- il peut être envoyé au convertisseur (5) analogique/numérique une tension (Up) de contrôle servant de signal de mesure et l'organe (7a) de correction élabore, s'il se produit une différence entre la valeur (R1) de référence et la valeur (R2) de la tension de contrôle, un nouveau facteur (K1, K2) de correction,
caractérisé en ce que le nouveau facteur de correction est le premier facteur (K1) de correction corrigé en fonction de la différence ou un facteur (K2) supplémentaire de correction, et en ce que le convertisseur analogique/numérique est raccordé pour le fonctionnement à une source (17) de tension de référence.

2. Dispositif électronique de mesure suivant la revendication 1, comprenant des moyens de contrôle cyclique de la différence.

3. Dispositif électronique de mesure suivant l'une des revendications 1 ou 2, dans lequel il est envoyé au convertisseur (5) analogique/numérique, en tant que signaux des mesure, des signaux de courant et de tension (U, I) et le dispositif (7) de traitement du signal comporte des moyens destinés à compter une consommation d'énergie.

4. Dispositif électronique de mesure suivant l'une des revendications 1 à 3, dans lequel le convertisseur (5) analogique/numérique comporte un modulateur sigma-delta.

5. Dispositif électronique de mesure suivant l'une des revendications 1 à 4, dans lequel le dispositif (7) de traitement du signal comporte un signal d'erreur lorsque la différence dépasse une valeur limite prescrite.
